# EUROPEAN PATENT APPLICATION

(11) **EP 4 376 107 A1**
(43) Date of publication of application: **29.05.2024**
(21) Application number: 23208203.2
(22) Date of filing: 07.11.2023
(51) Int. Cl.: H01L 33/48, H01L 25/16, H01L 33/60, H01L 33/62

(54) **LIGHT EMITTING DIODE PACKAGE AND MANUFACTURING METHOD OF THE SAME, AND LIGHT EMITTING DEVICE**

(30) Priority: 22.11.2022 KR 20220157063
(71) Applicant: LG Display Co., Ltd., Seoul 07336 (KR)
(72) Inventor: JUNG, Sunghyun, 10845 Paju-si (KR); PARK, Kiduck, 10845 Paju-si (KR); SON, Chulgoo, 10845 Paju-si (KR); SEO, Jeongho, 10845 Paju-si (KR)
(74) Representative: Viering, Jentschura & Partner mbB Patent- und Rechtsanwälte

(57) **Abstract**

Embodiments relate to a light-emitting diode package (100) and a manufacturing method thereof and a light emitting device. The light-emitting diode package (100) includes a lead frame (110) comprising a substrate and leads formed on the substrate, a light-emitting diode chip (120) mounted on the lead frame (110) and electrically connected to the lead frame (110), an electrostatic discharge protection member (140) mounted on the lead frame (110) and electrically connected to the lead frame (110), a molding member (130) comprising a wall surrounding components of the light-emitting diode package (100), the wall attached to the outer periphery of the lead frame (110), and the wall defining a cavity together with the lead frame (110), and a bead member (150) covering a surface of the electrostatic discharge protection member (140), wherein the bead member (150) comprises beads (151) inducing diffuse reflection of light emitted from the light-emitting diode chip (120) and incident on the electrostatic discharge protection member (140).

## Description

### CROSS-REFERENCE TO RELATED APPLICATION

The present application claims the benefit of Republic of Korea Patent Application No. 10-2022-0157063, filed on November 22, 2022.

### BACKGROUND

### Technical Field

The present disclosure relates to a light-emitting diode package, a method for manufacturing the same, and a light-emitting device.

### Description of the Related Art

Light-emitting diodes (LEDs) are environment-friendly as they have high luminous efficiency, long lifespan, and low power consumption. In addition, light-emitting diodes can be manufactured with a package structure that incorporates a light-emitting diode chip, allowing for a wide range of applications depending on the intended use or form factor.

Typically, a light-emitting diode package may include a light-emitting diode chip, a lead frame that supplies power to the light-emitting diode chip, and a molding member that supports the lead frame and protects the light-emitting diode chip. Furthermore, a light-emitting diode package may incorporate a Zener diode to protect the LED chip against potential damage from external electrostatic discharge.

The description provided in the background section should not be assumed to be prior art merely because it is mentioned in or associated with the background section. The background section may include information that describes one or more aspects of the subject technology.

### SUMMARY

It is newly recognized by inventors of the present disclosure that, in such light-emitting diode packages, the Zener diode may absorb a portion of the light generated by the LED chip, leading to a reduction in the luminous efficiency and the potential occurrence of uneven light output across the entire package.

Therefore, the inventors of the present disclosure recognized the problems mentioned above and other limitations associated with the related art, and conducted various experiments to implement a light-emitting diode package and manufacturing method thereof and a light-emitting device that minimizes or reduces the absorption of light by components such as Zener diodes, thereby improving the light emission efficiency of the LED package and reducing uneven light output.

Embodiments provide a light-emitting diode package and manufacturing method thereof and a light-emitting device that facilitates the scattering of the light generated by the LED chip upward and sideward by covering the Zener diode with a bead member.

Additional features and aspects of the disclosure are set forth in part in the description that follows and in part will become apparent from the description or may be learned by practice of the inventive concepts provided herein. Other features and aspects of the inventive concepts may be realized and attained by the structures pointed out in the present disclosure, or derivable therefrom, and the claims hereof as well as the appended drawings. Embodiments of the present disclosure provide a light-emitting diode package and a method of manufacturing a light-emitting diode package as described in the independent claims. Further embodiments are described in the dependent claims.

According to an embodiment, a light-emitting diode package may include a lead frame comprising a substrate and leads formed on the substrate, a light-emitting diode chip mounted on the lead frame and electrically connected to the lead frame, an electrostatic discharge protection member mounted on the lead frame and electrically connected to the lead frame, a molding member comprising a wall surrounding and attached to the outer periphery of the lead frame and defining a cavity together with the lead frame, and a bead member covering a surface of the electrostatic discharge protection member, wherein the bead member includes beads inducing diffuse reflection of light emitted from the light-emitting diode chip and incident on the electrostatic discharge protection member.

The bead member may include a resin including a translucent material and the beads dispersed within the resin.

The beads may include one selected among silicon, silica, glass bubble, polymethyl methacrylate (PMMA), urethane, Zn, Zr, Al₂O₃, TiO₂ and acrylic, a fluorescent material including at least one of amber fluorescent material, yellow fluorescent material, green fluorescent material, or white fluorescent material, or ink particles including at least one of metallic ink, ultraviolet (UV) ink, or curing ink.

The beads may have a diameter ranging from approximately 9 nm to 20 µm.

The lead frame may include a first lead member and a second lead member arranged to have a gap, which is filled with an insulating member.

The insulating member may be integrally formed with the molding member.

The light-emitting diode chip may include a first light-emitting diode chip arranged on the first lead member and a second light-emitting diode chip arranged on the second lead member, wherein the electrostatic discharge protection member may be arranged on the first lead member.

The first light-emitting diode chip may be wire-bonded to the second lead member, the second light-emitting diode chip may be wire-bonded to the first lead member, the first light-emitting diode chip and the second light-emitting diode chip may be wire-bonded to each other, and the electrostatic discharge protection member may be wire-bonded to the second lead member.

The wall of the molding member may include an inner surface having one or more slope angles.

The light-emitting diode package may further include a resin layer filling the cavity.

The electrostatic discharge protection member may be a Zener diode.

According to an embodiment, a method of manufacturing a light-emitting diode package may include mounting a light-emitting diode chip and an electrostatic discharge protection member (e.g., a Zener diode) on a lead frame to which a molding member is attached, wire-bonding the light-emitting diode chip and the electrostatic discharge protection member (e.g., Zener diode) to the lead frame, forming a bead member covering the surface of the electrostatic discharge protection member (e.g., Zener diode), and filling a cavity inside of the molding member with a resin layer, wherein the bead member may include beads inducing diffuse reflection of light emitted from the light-emitting diode chip and incident on the electrostatic discharge protection member.

Mounting the light-emitting diode chip and the electrostatic discharge protection member (e.g., Zener diode) on the lead frame may include attaching the light-emitting diode chip and the electrostatic discharge protection member (e.g., Zener diode) to the lead frame via an adhesive member.

Forming the bead member may include covering an outer surface of the electrostatic discharge protection member (e.g., Zener diode) with a resin dot including the beads and curing the resin dot.

The resin layer may be formed by filling a resin material in the cavity formed by the lead frame and a wall of the molding member and curing the resin material.

According to an embodiment, a light emitting device may include a control board comprising leads for delivering external power and control signals on a substrate, at least one light-emitting diode package according to one or more embodiments described herein, mounted on the control board, and a lens member mounted on the control board to cover each light-emitting diode package.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, that may be included to provide a further understanding of the disclosure and may be incorporated in and constitute a part of the disclosure, illustrate embodiments of the disclosure and together with the description serve to explain various principles of the disclosure.
FIG. 1 is a cross-sectional view of a light-emitting diode package according to an embodiment of the present disclosure;
FIGS. 2 and 3 are diagrams illustrating the issue of uneven light emission observed in the light-emitting diode package of FIG. 1, according to an embodiment of the present disclosure;
FIG. 4 illustrates an example of a light-emitting device with a light-emitting diode package implemented according to an example embodiment of the present disclosure;
FIG. 5 illustrates an example of a perspective view of a region of the light-emitting device of FIG. 4, according to an embodiment of the present disclosure;
FIG. 6 illustrates an example of a cross-sectional view of a region of the light-emitting device of FIG. 4, according to an embodiment of the present disclosure;
FIG. 7 illustrates an example of a plan view of a region of a light-emitting diode package according to an example embodiment of the present disclosure;
FIG. 8 illustrates an example of a cross-sectional view of the light-emitting diode package as viewed in direction A in FIG. 7, according to an embodiment of the present disclosure;
FIG. 9 illustrates an example of a cross-sectional view of the light-emitting diode package as viewed in direction B in FIG. 7, according to an embodiment of the present disclosure;
FIG. 10 is a circuit diagram schematically illustrating an electrical connection state of a light-emitting diode chip, according to an embodiment of the present disclosure;
FIG. 11 and FIG. 12 are diagrams illustrating improvement of uneven light emission in the light-emitting diode package according to an example embodiment of the present disclosure; and
FIG. 13 to FIG. 16 are diagrams illustrating a method of manufacturing a light-emitting diode package according to an example embodiment of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Reference will now be made in detail to embodiments of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations may be selected only for convenience of writing the specification and may be thus different from those used in actual products.

Advantages and features of the present disclosure, and implementation methods thereof will be clarified through following example embodiments described with reference to the accompanying drawings. The present disclosure may, however, be embodied in different forms and should not be construed as limited to the example embodiments set forth herein. Rather, these example embodiments may be provided so that this disclosure may be sufficiently thorough and complete to assist those skilled in the art to fully understand the scope of the present disclosure. Further, the present disclosure is only defined by scopes of claims.

The shapes, sizes, ratios, angles, numbers, and the like, which are illustrated in the drawings to describe various example embodiments of the present disclosure are merely given by way of example. Therefore, the present disclosure is not limited to the illustrations in the drawings. The same or similar elements are designated by the same reference numerals throughout the specification unless otherwise specified. In the following description where the detailed description of the relevant known function or configuration may unnecessarily obscure an important point of the present disclosure, a detailed description of such known function of configuration may be omitted.

Hereinafter, embodiments will be described with reference to accompanying drawings. In the specification, when a component (or area, layer, part, etc.) is mentioned as being "on top of," "connected to," or "coupled to" another component, it means that it may be directly connected/coupled to the other component, or a third component may be placed between them.

The same reference numerals refer to the same components. In addition, in the drawings, the thickness, proportions, and dimensions of the components are exaggerated for effective description of the technical content. The expression "and/or" is taken to include one or more combinations that can be defined by associated components.

The terms "first," "second," etc. are used to describe various components, but the components should not be limited by these terms. The terms are used only for distinguishing one component from another component, and the essence, sequence, order, or number of the corresponding component should not be limited by these terms. For example, a first component may be referred to as a second component and, similarly, the second component may be referred to as the first component, without departing from the scope of the present disclosure. As used herein, the singular forms are intended to include the plural forms as well, unless the context clearly indicates otherwise. Also, when an element or layer is described as being "connected," "coupled," or "adhered" to another element or layer, the element or layer can not only be directly connected, or adhered to that other element or layer, but also be indirectly connected, or adhered to that other another element or layer with one or more intervening elements or layers "disposed," between the elements or layers, unless otherwise specified.

The terms such as "on," "over," "under," "beneath," "near," "close to," or "adj acent to," "beside," and "next, to," "below," "lower," "above," "upper," etc. are used to describe the relationship of components depicted in the drawings. The terms are relative concepts and are described based on the direction indicated on the drawing, but the present disclosure is not limited thereto.

It will be further understood that the terms "comprises," "has," "include," and the like are intended to specify the presence of stated features, numbers, steps, operations, components, parts, or a combination thereof but are not intended to preclude the presence or possibility of one or more other features, numbers, steps, operations, components, parts, or combinations thereof. Any implementation described herein as an "example" is not necessarily to be construed as preferred or advantageous over other implementations.

In construing an element, the element is construed as including an error range or tolerance range although there is no explicit description of such an error or tolerance range.

Features of various embodiments of the present disclosure may be partially or overall coupled to or combined with each other, and may be variously inter-operated with each other and driven technically as those skilled in the art can sufficiently understand. Embodiments of the present disclosure may be carried out independently from each other, or may be carried out together in co-dependent relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Hereinafter, embodiments of the present disclosure will be described in detail with reference to the accompanying drawings.

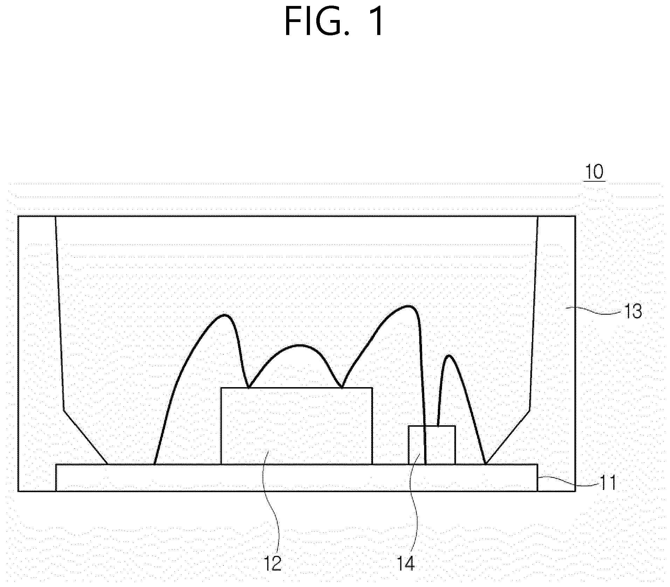

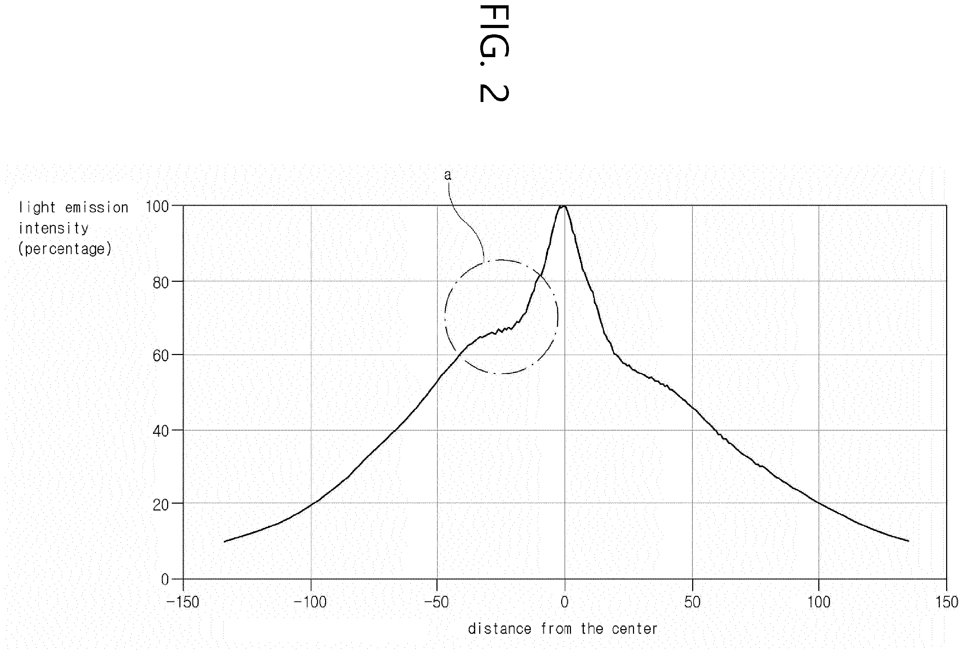

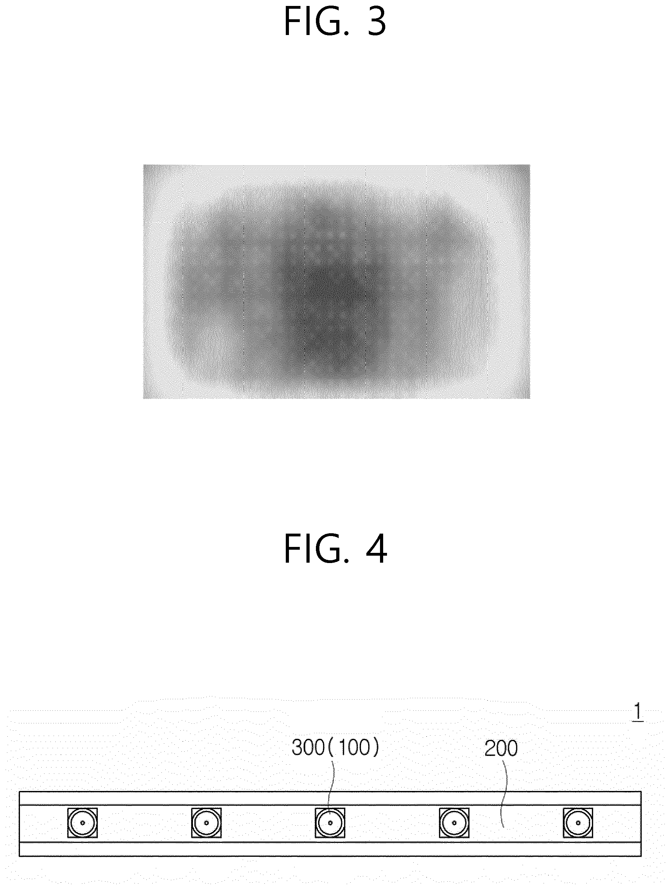

FIG. 1 is a cross-sectional view of a light-emitting diode package according to an embodiment of the present disclosure; FIGS. 2 and 3 are diagrams illustrating the issue of uneven light emission observed in the light-emitting diode package of FIG. 1, according to an embodiment of the present disclosure.

With reference to FIG. 1, the light-emitting diode package 10 may include a lead frame 11, a light-emitting diode chip 12 mounted within the lead frame 11, and a molding member 13 supporting the lead frame 11 and sealing the periphery of components (e.g., the light-emitting diode chip 12) positioned on the lead frame 11.

The light-emitting diode package 10 may include a Zener diode 14 as an electrostatic discharge protection element positioned on the lead frame 11. The light-emitting diode chip 12 and Zener diode 14 may be wire-bonded to the leads (for example, electrodes or pads) formed on the lead frame 11.

The light emitted from the light-emitting diode chip 12 in such a light-emitting diode package 10 is partially absorbed by the adjacent Zener diode 14. In this case, uneven light emission, indicated by area "a" in FIG. 2, may occur around the Zener diode 14, leading to the appearance of external lens mura (spots), as depicted in FIG. 3.

Hereinafter, a description is made of an improved structure of the light-emitting diode package to address this issue.

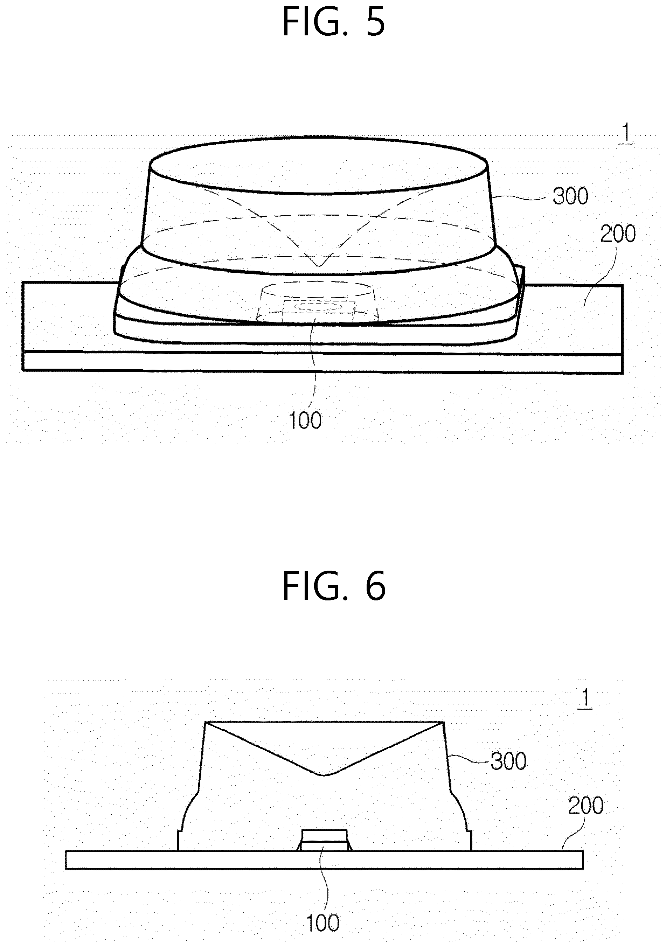

FIG. 4 illustrates an example of a light-emitting device with a light-emitting diode package implemented according to an example embodiment of the present disclosure. FIG. 5 illustrates an example of a perspective view of a region of the light-emitting device of FIG. 4, according to an embodiment of the present disclosure. FIG. 6 illustrates an example of a cross-sectional view of a region of the light-emitting device of FIG. 4, according to an embodiment of the present disclosure.

With reference to FIG. 4 to FIG. 6, the light-emitting device 1 may include a light-emitting diode package 100, a control board 200, and a lens member 300.

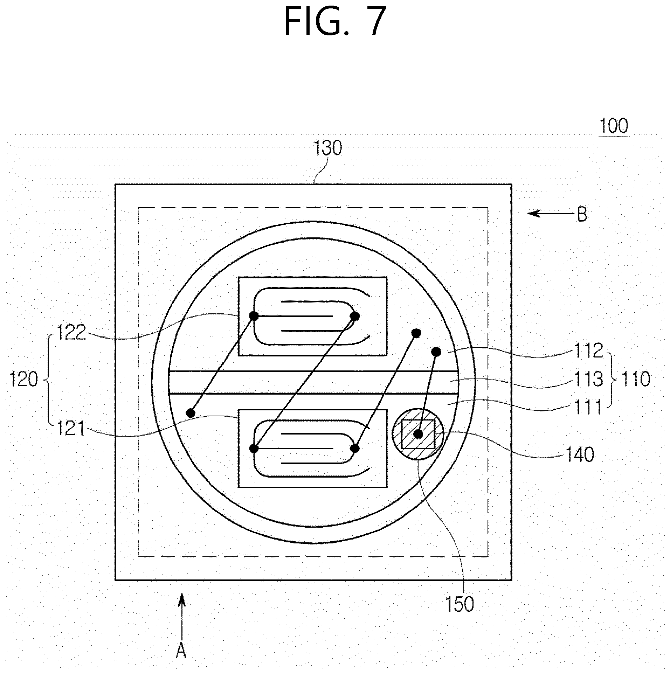

The light-emitting diode package 100 may include a light-emitting diode chip (120 in FIGS. 7 to 9) and may emit light based on the power and control signals supplied through the lead frame (110 in FIGS. 7 to 9).

The light-emitting diode package 100 may be mounted on the control board 200. The control board 200 may be a printed circuit board (PCB) or a flexible printed circuit board (FPCB) made of flexible material. Alternatively, the control board 200 may include a synthetic resin board, such as resin or glass epoxy, with leads formed on a ceramic substrate. The light-emitting diode package 100 may be electrically connected to the control board 200 through the leads formed on the lead frame 110. The light-emitting diode package 100 may receive external power and/or control signals from the control board 200.

As needed, a plurality of light-emitting diode packages 100 may be mounted on the control board 200 as shown in the drawings. However, this embodiment is not limited thereto. For example, the number of light-emitting diode packages 100 mounted on the control board 200 may be one, two, three or more.

The light-emitting diode packages 100 may be covered by a lens member 300. A cavity capable of accommodating the light-emitting diode packages 100 may be formed on the underside of the lens member 300. The lens member 300 may be mounted on the control board 200 with the light-emitting diode packages 100 accommodated within the cavities. The lens member 300 serves to protect the light-emitting diode packages 100 from external elements and widens the area of light diffusion emitted from the light-emitting diode packages 100, thereby reducing the number of light-emitting diode packages 100 required.

In an embodiment, the lens member 300 is depicted as having a cylindrical shape with a concave top surface. However, this embodiment is not limited thereto, and the lens member 300 may have various shapes depending on the desired light output configuration or profile. For example, the lens member 300 may have various shapes such as hemispherical, ellipsoidal bullet, flat, hexagonal, and square shapes. As long as the design requirement for protecting the light-emitting diode packages 100 from external elements and/or widening the area of light diffusion emitted from the light-emitting diode packages 100 is satisfied, the lens member 300 may be variously modified.

In various embodiments, the lens member 300 may be textured or incorporate materials such as phosphors or scattering particles to enhance light emission efficiency.

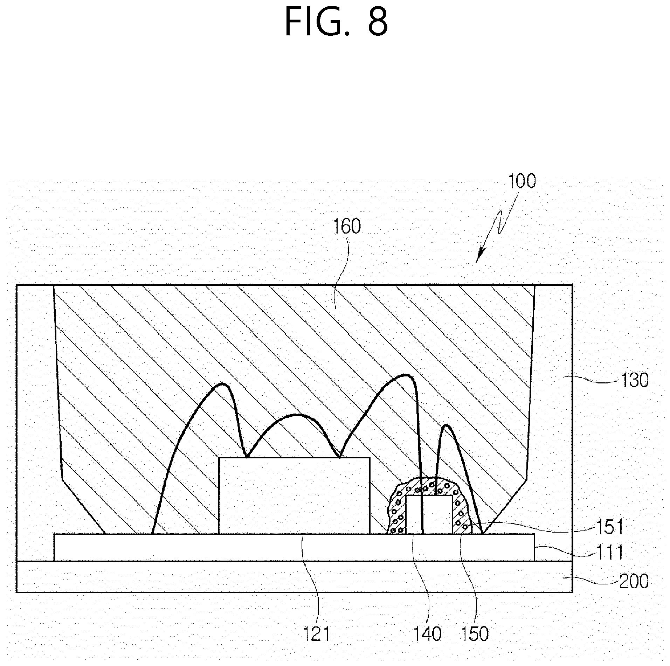

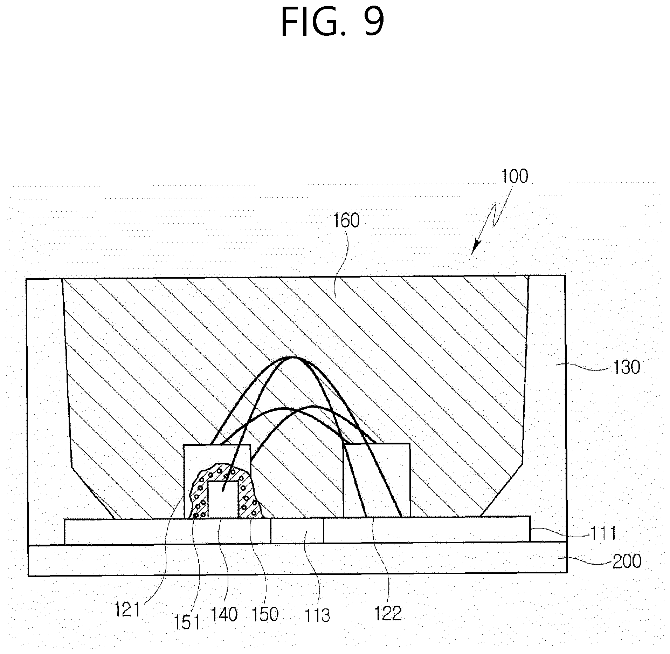

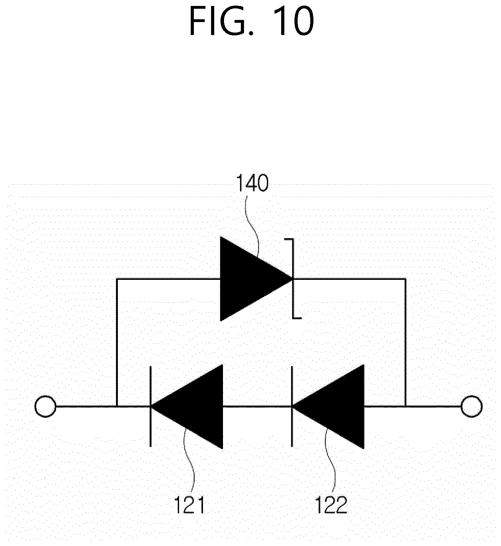

FIG. 7 illustrates an example of a plan view of a region of a light-emitting diode package according to an example embodiment of the present disclosure. FIG. 8 illustrates an example of a cross-sectional view of the light-emitting diode package as viewed in direction A in FIG. 7, according to an embodiment of the present disclosure. FIG. 9 illustrates an example of a cross-sectional view of the light-emitting diode package as viewed in direction B in FIG. 7, according to an embodiment of the present disclosure. FIG. 10 is a circuit diagram schematically illustrating an electrical connection state of a light-emitting diode chip, according to an embodiment of the present disclosure.

With reference to FIGS. 7 to 9, a light-emitting diode package 100 according to another example embodiment is formed on the control board 200 depicted in FIG. 4. The light-emitting diode package 100 may include a lead frame 110, a light-emitting diode chip 120, and a molding member 130.

The lead frame 110 is provided to supply external power and control signals to components such as the light-emitting diode chip 120. The lead frame 110 may include leads formed on the substrate for electrical connections with the substrate and external components.

In an embodiment, the lead frame 110 may include a first lead member 111 and a second lead member 112. The first lead member 111 and the second lead member 112 may be joined to the molding member 130 in a spaced-apart manner. The first lead member 111 and the second lead member 112 may have the same or different areas on a flat plane.

In an embodiment, the spaced-apart gap between the first lead member 111 and the second lead member 112 may be filled with an insulating member 113 to electrically insulate the first lead member 111 and the second lead member 112. In the embodiment, the insulating member 113 may include (e.g., may be made of) the same material as the molding member 130, which is to be described later, either integrally with or independently of the molding member 130. For example, the insulating member 113 may be formed as a single component physically connected to the molding member 130 on the underside or the side of the light-emitting diode package 100. However, this embodiment is not limited thereto.

The light-emitting diode chip 120 may emit light of a predetermined wavelength in response to the power and control signals supplied from outside. For example, the light-emitting diode chip 120 may emit light with a predetermined intensity depending on the magnitude of the voltage or current determined by the control signals.

The light-emitting diode chip 120 may include a semiconductor. For example, the light-emitting diode chip 120 may include blue, green, red, yellow, white, cyan, magenta, or ultraviolet light-emitting diodes including nitride or oxide semiconductors.

Although a single light-emitting diode chip 120 is placed within the molding member 130 in the drawing, this embodiment is not limited thereto. For example, in various other embodiments, multiple light-emitting diode chips 120 may be arranged within the molding member 130. In such embodiments, multiple light-emitting diode chips 120 may emit light of the same or different wavelengths, and the emission characteristics of the light-emitting diode package 100 may be determined by the combination of light emitted from multiple light-emitting diode chips 120.

The light-emitting diode chip 120 is placed on the lead frame 110. The light-emitting diode chip 120 may be mounted on the first lead member 111 and the second lead member 112. In the illustrated embodiment, the light-emitting diode chip 120 includes a first light-emitting diode chip 121 positioned on the first lead member 111 and a second light-emitting diode chip 122 positioned on the second lead member 112. In other embodiments, however, the light-emitting diode chip 120 may be selectively positioned on either the first lead member 111 or the second lead member 112. In addition, the number of light-emitting diode chips is not limited to the present disclosure.

The light-emitting diode chip 120 can be electrically connected to the lead frame 110. For example, the light-emitting diode chip 120 may be wire-bonded to the leads (for example, electrodes or pads) formed on the lead frame 110. In the illustrated embodiment, the first light-emitting diode chip 121 positioned on the first lead member 111 may be wire-bonded to the second lead member 112. Likewise, the second light-emitting diode chip 122 positioned on the second lead member 112 may be wire-bonded to the first lead member 111. In an embodiment, the first light-emitting diode chip 121 and the second light-emitting diode chip 122 may also be connected to each other through wiring.

The molding member 130 may seal and protect the other components of the light-emitting diode package 100 from external forces and other factors. The molding member 130 may include a wall that surrounds and attaches to the outer periphery of the lead frame 110, supporting the lead frame 110 and defining cavities. For example, the wall of the molding member 130 may be joined with the lead frame 110 to form a cavity with a concave shape open upward. Although the molding member 130 is depicted with a square cross-section in this embodiment, the shape of the molding member may vary in alternative embodiments.

The wall of the molding member 130 may be formed to have an inner surface having a sloped shape. For example, the inner surface of the molding member 130 may include inclined surfaces with one or more slope angles. With this shape, the inner surface of the molding member 130 may serve as a reflective surface that reflects the light emitted from the light-emitting diode chip 120. This reflective surface may prevent or reduce the light emitted from the light-emitting diode chip 120 from interfering with the light emitted from neighboring light-emitting diode packages.

To enhance the reflective function, the molding member 130 may be implemented with a metal such as aluminum, silver coating, gold coating, ceramic materials or nanocomposite materials. Alternatively, the molding member 130 may be implemented using various materials such as an epoxy resin composition, a silicone resin composition, a modified epoxy resin composition such as silicone-modified epoxy resin, a modified silicone resin composition such as epoxy-modified silicone resin, a polyimide resin composition, a modified polyimide resin composition, polyphthalamide (PPA), polycarbonate (PC) resin, polyphenylene sulfide (PPS), liquid crystal polymer (LCP), acrylonitrile butadiene styrene (ABS) resin, phenolic resin, acrylic resin, polybutylene terephthalate (PBT) resin, and the like. Furthermore, one or more of these resins may contain light-reflective materials such as titanium oxide, silicon dioxide, titanium dioxide, zirconium dioxide, potassium titanate, alumina, aluminum nitride, boron nitride, mullite, chromium, white-based or metal-based elements. The slope of the reflective surface may be formed at various angles without any specific limitations. Alternatively, the reflective function of the molding member may be achieved by the total-reflection of the light incident on an interface between the molding member and the air or the resin layer. Such total-reflection may be induced by the refractive index difference between the molding member and the resin layer or air disposed in the cavity. In addition, it is to be noted that the arrangement or structure of the molding member is not limited to that described in the above embodiments, and may be variously changed as necessary.

According to an embodiment, the light-emitting diode package 100 may include an electrostatic discharge protection member 140 (henceforth also referred to as electrostatic discharge protection component) to prevent or reduce damage to the light-emitting diode chip 120 caused by external electrostatic discharge. An example of the electrostatic discharge protection component 140 may be, but is not limited to, a Zener diode. In alternative embodiments, the electrostatic discharge protection component 140 may be made using components such as a varistor, a multilayer varistor (MLV), a polymer electrostatic discharge (PESD) suppressor, or a transient voltage suppressor (TVS). In the following, the electrostatic discharge protection member 140 will be described as a Zener diode as a non-limiting example.

The Zener diode 140 may be mounted on the lead frame 110. In the illustrated embodiment, the Zener diode 140 is positioned on the first lead member 111. However, this embodiment is not limited thereto.

On the lead frame 110, the Zener diode 140 may be positioned at a certain distance from the light-emitting diode chip 120. In an example embodiment, the distance between the Zener diode 140 and the first light-emitting diode chip 121 adjacent to the Zener diode 140 may be approximately 0.18 mm to 0.25 mm, but the present disclosure is not limited thereto.

The Zener diode 140 may be electrically connected to the lead frame 110. For example, the Zener diode 140 may be wire-bonded to the leads (for example, electrodes or pads) formed on the lead frame 110. In an example embodiment, the Zener diode 140 positioned on the first lead member 111 may be wire-bonded to the second lead member 112.

By means of such wire bonding, it may be possible to achieve an electrical connection state as shown in FIG. 10. The first light-emitting diode chip 121 and the second light-emitting diode chip 122 may be connected in series through wire bonding between the terminals of the first lead member 111 and the second lead member 112. The Zener diode 140, positioned on the first lead member 111, may be connected, on one side thereof, to the terminal of the first lead member 111 and to the terminal of the second lead member 112, on the other side thereof, through wire bonding. The Zener diode 140 may be connected in parallel with the light-emitting diode chip 120, allowing the excessive current caused by electrostatic discharge or other factors applied to the light-emitting diode chip 120 to be discharged to the outside through the lead frame 110.

In an example embodiment, the light-emitting diode package 100 may further include a bead member 150 that covers the Zener diode 140. The bead member 150 may be formed on the lead frame 110 to thinly cover the surface of the Zener diode 140. The bead member 150 may scatter and reflect the light generated by the light-emitting diode chip 120 and emitted towards the Zener diode 140, directing the light upwards.

The bead member 150 may include beads 151 dispersed within a resin. The resin may include transparent materials such as silicone or epoxy. The beads may include any of silicon, silica, glass bubble, polymethyl methacrylate (PMMA), urethane, Zn, Zr, Al₂O₃, TiO₂ or acrylic. Alternatively, the beads 151 may include fluorescent particles or ink particles. The fluorescent particles may include at least one of amber fluorescent particles, yellow fluorescent particles, green fluorescent particles, or white fluorescent particles, and the ink particles may include at least one of metallic ink, UV ink, or curing ink, for example.

The beads 151 may have a diameter ranging from approximately 9 nm to 20 µm, but are not limited thereto. For example, the diameter of the beads 151 may be in a range from 90 nm to 2 µm, but are not limited thereto.

The beads 151 may induce the diffuse reflection of incident light, thereby increasing haze around the Zener diode 140. Through presence of the bead member 150, the incident light directed towards the Zener diode 140 may be emitted as uniform surface light.

As a result of the diffuse reflection caused by the bead member 150, light from the light-emitting diode chip 120 may be uniformly emitted in the upward direction, and the Zener diode 140 may be invisible from the outside.

The bead member 150 may be formed by covering (for example, coating) and curing (for example, drying) the resin in which the beads 151 are dispersed. Accordingly, the surface of the bead member 150 may have an uneven shape as shown in the drawing. However, this embodiment is not limited thereto. For example, the resin in which the beads 151 are dispersed may be cured by light such as visible light or ultraviolet, or heat, but the present disclosure is not limited thereto.

The interior (cavity) of the molding member 130 may be filled with a resin layer 160. The resin layer 160 may include a transparent material such as silicone or epoxy. The resin layer 160 may also include other materials such as glass. Alternatively, the resin layer 160 may include at least one of silicon-based materials, silicone molding compounds (SMC), epoxy-based materials, or epoxy molding compounds (EMC). The resin layer 160 may include ultraviolet (UV) curable resin or heat-curable resin materials, and optionally include materials such as PC, oriented polystyrene (OPS), PMMA, polyvinyl chloride (PVC), and the like. For example, the main material of the resin layer 160 may be a resin using urethane acrylate oligomer as the primary ingredient.

In an example embodiment, the resin layer 160 may include fluorescent material. The fluorescent material may be provided to alter the wavelength of light. The fluorescent material may include at least one of yellow, green, blue, or red fluorescent materials, but is not limited thereto. The fluorescent material may selectively include quantum dots, yttrium aluminum garnet (YAG), terbium aluminum garnet (TAG), silicate, nitride, or oxy-nitride materials.

The resin layer 160 may emit the light emitted from the light-emitting diode chip 120 in the form of a linear light source or a surface light source.

It is to be noted that, although the embodiments of the present disclosure are described as a light-emitting diode package or light emitting device including an electrostatic discharge protection member, the present disclosure is not limited thereto. For example, any component disposed in the light-emitting diode package or light emitting device that may absorb or block a portion of the light generated by the LED chip may be covered by the bead member described above, so as to improve light output uniformity. In the present disclosure, such component may be a light-absorption member or light-blocking member.

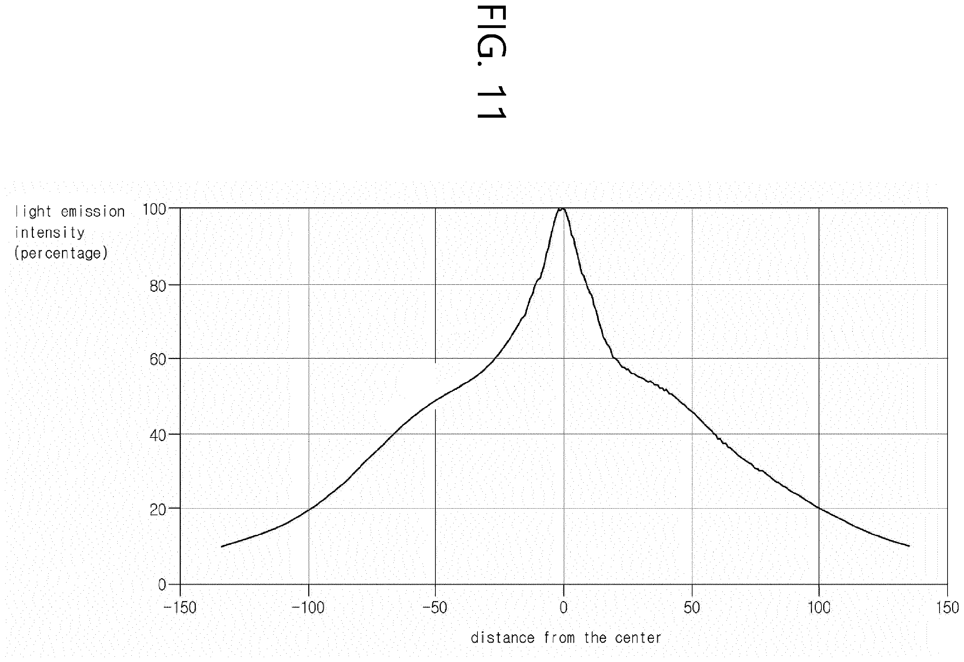

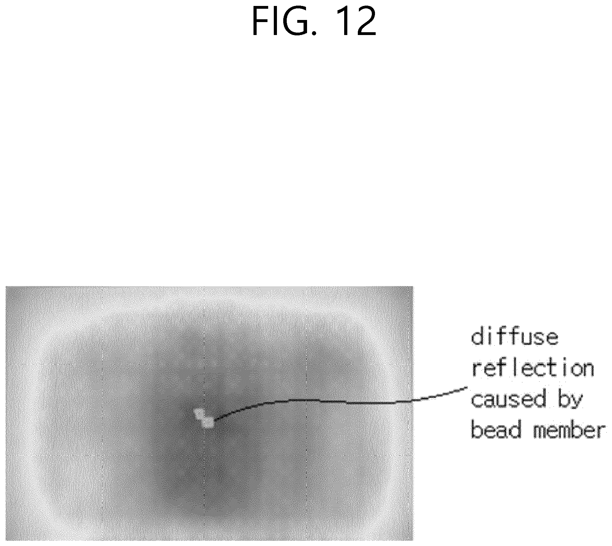

FIG. 11 and FIG. 12 are diagrams illustrating improvement of uneven light emission in the light-emitting diode package according to an example embodiment of the present disclosure.

As described above, the light generated from the light-emitting diode chip 120 may be partially emitted towards the adjacent Zener diode 140 due to their close arrangement. The light incident on the Zener diode 140 may be diffusely reflected by the bead member 150 covering the Zener diode 140, resulting in uniform directional light emission. Through such diffuse reflection, the Zener diode 140 may facilitate uniform light emission from the front, including its surroundings, of the light-emitting diode package 100, as observed in FIG. 11. As a result, no lens mura is visible from the outside as shown in FIG. 12.

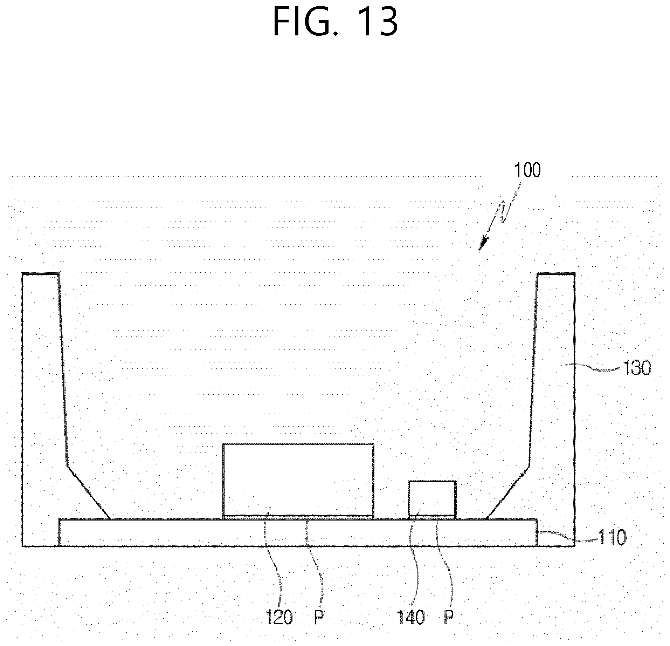

FIG. 13 to FIG. 16 are diagrams illustrating a method of manufacturing a light-emitting diode package according to an embodiment of the present disclosure.

With reference to FIG. 13, the molding member 130 may be first bonded to the lead frame 110, and the light-emitting diode chip 120 and the Zener diode 140 (as an example of an electrostatic discharge protection member) may be mounted on the lead frame 110. After or before being electrically connected to the lead frame 110, the light-emitting diode chip 120 and the Zener diode 140 may be fixed on the lead frame 110 by means of an adhesive member P. The molding member 130 may be attached to the outer periphery of the lead frame 110 to support the lead frame 110.

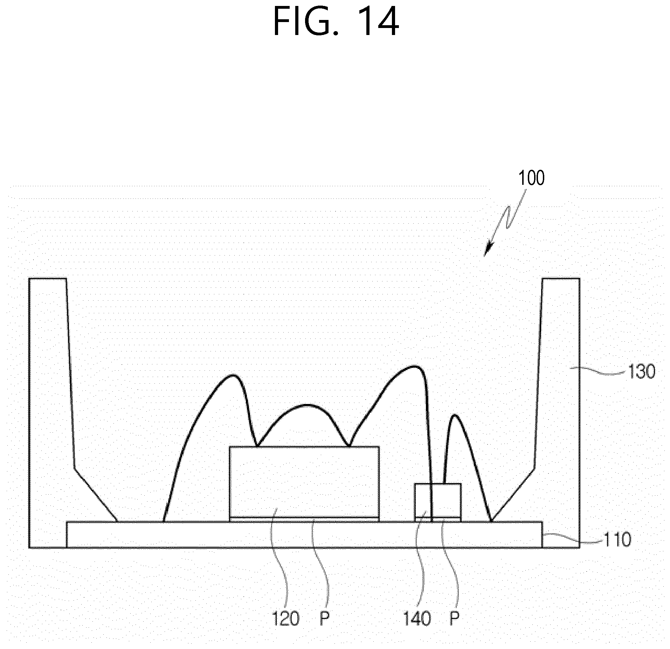

Next, the light-emitting diode chip 120 and the Zener diode 140 may be wire-bonded to the lead frame 110 as shown in FIG. 14.

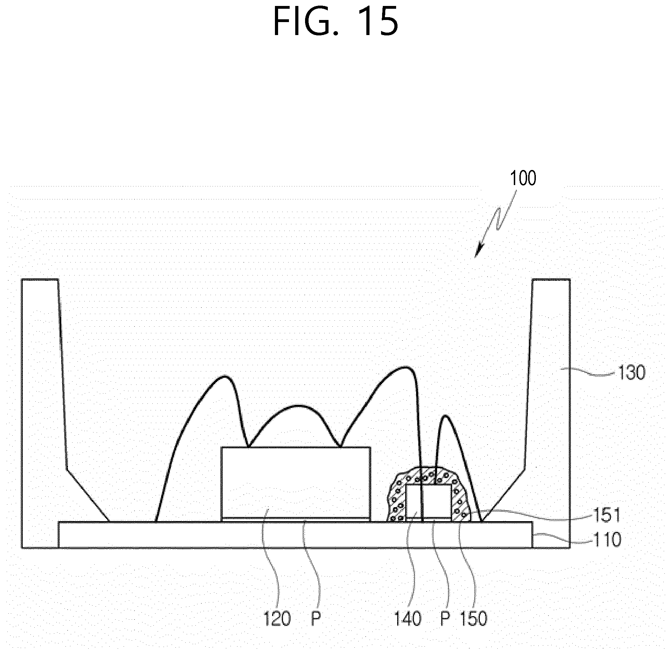

Subsequently, the bead member 150 may be formed on the Zener diode 140 as shown in FIG. 15. The bead member 150 may be formed by applying a resin dot containing the beads 151 onto the outer surface of the Zener diode 140 and then curing (for example, drying) the resin dot.

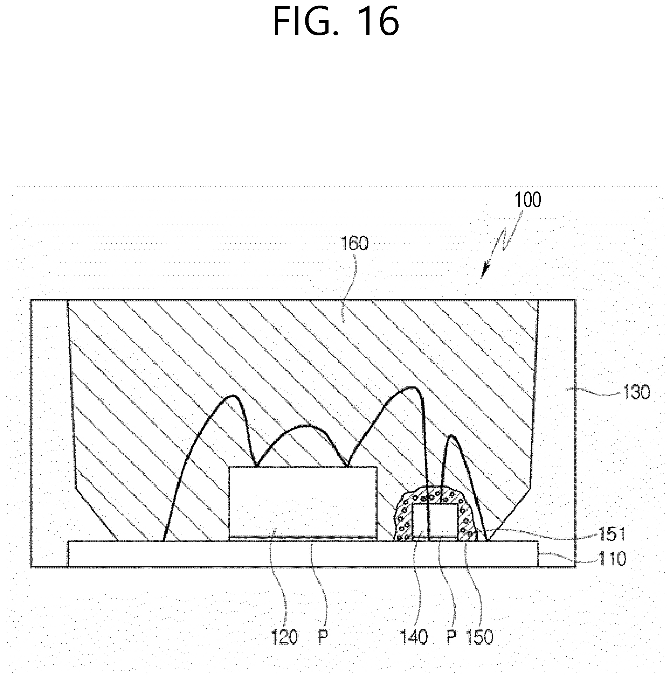

Next, the resin layer 160 may fill the cavity inside the molding member 130, as shown in FIG. 16. The resin layer 160 may be formed by filling the cavity with a resin material and then curing the resin material. However, the present disclosure is not limited thereto. For example, the resin layer 160 may be omitted.

The resin material used in the resin layer 160 may be the same as or different from the resin material used to form the bead member 150. However, since the bead member 150 contains the beads 151, the resin layer 160 and the bead member 150 may be distinguished from each other materially or visually.

The light-emitting diode package and manufacturing method thereof according to example embodiments is capable of increasing the light emission efficiency of the LED chip by minimizing or reducing the light absorption of components such as Zener diodes.

Although example embodiments of the present disclosure have been described above with reference to the accompanying drawings, it will be understood that the technical configuration of the present disclosure described above can be implemented in other specific forms by those skilled in the art without changing the technical concept or essential features of the present disclosure. Therefore, it should be understood that the example embodiments described above are exemplary and not limited in all respects. Furthermore, the scope of the present disclosure is defined by the claims set forth below, rather than the detailed description above. In addition, it should be understood that all modifications or variations derived from the meaning and scope of the claims are included within the scope of the present disclosure.

## Claims

1. A light-emitting diode package (100) comprising:
a lead frame (110) comprising a substrate and leads on the substrate;
a light-emitting diode chip (120) mounted on the lead frame (110), the light-emitting diode chip (120) electrically connected to the lead frame (110);
an electrostatic discharge protection member (140) mounted on the lead frame (110), the electrostatic discharge protection member (140) electrically connected to the lead frame (110);
a molding member (130) attached to the lead frame (110); and
a bead member (150) covering a surface of the electrostatic discharge protection member (140), the bead member (150) comprising beads (151) inducing diffuse reflection of light emitted from the light-emitting diode chip (120) and incident on the electrostatic discharge protection member (140).

2. The light-emitting diode package (100) of claim 1, wherein the bead member (150) comprises:
a resin including a translucent material, the beads (151) dispersed within the resin,
wherein, preferably, the beads (151) have a diameter ranging from 9 nm to 20 µm.

3. The light-emitting diode package (100) of claim 2, wherein the beads (151) include one selected among silicon, silica, glass bubble, polymethyl methacrylate (PMMA), urethane, Zn, Zr, Al₂O₃, and acrylic, or a fluorescent material including at least one of amber fluorescent material, yellow fluorescent material, green fluorescent material, or white fluorescent material, or ink particles including at least one of metallic ink ultraviolet (UV) ink, or curing ink.

4. The light-emitting diode package (100) of any of claims 1 to 3, wherein the lead frame (110) comprises a first lead member (111) and a second lead member (112) arranged to have a gap, the gap filled with an insulating member (113),
wherein, preferably, the insulating member (113) is integral with the molding member (130).

5. The light-emitting diode package (100) of claim 4, wherein the light-emitting diode chip (120) comprises:
a first light-emitting diode chip (121) on the first lead member (111); and
a second light-emitting diode chip (122) on the second lead member (112), wherein the electrostatic discharge protection member (140) is on the first lead member (111).

6. The light-emitting diode package (100) of claim 5, wherein the first light-emitting diode chip (121) is wire-bonded to the second lead member (112), the second light-emitting diode chip (122) is wire-bonded to the first lead member (111), the first light-emitting diode chip (121) and the second light-emitting diode chip (122) are wire-bonded to each other, and the electrostatic discharge protection member (140) is wire-bonded to the second lead member (112),
wherein, preferably, the first light-emitting diode chip (121) and the second light-emitting diode chip (122) are connected in series, and the electrostatic discharge protection member (140) is connected in parallel with the first light-emitting diode chip (121) and the second light-emitting diode chip (122).

7. The light-emitting diode package (100) of any of claims 1 to 6, wherein the molding member (130) surrounds and is attached to an outer periphery of the lead frame (110) and comprises a wall defining a cavity together with the lead frame (110).

8. The light-emitting diode package (100) of claim 7, wherein the wall of the molding member (130) comprises an inner surface having one or more slope angles.

9. The light-emitting diode package (100) of claim 7 or 8, further comprising:
a resin layer (160) filling the cavity,
wherein, preferably, the bead member (150) includes a same material as the resin layer (160).

10. A method of manufacturing a light-emitting diode package (100), the method comprising:
mounting a light-emitting diode chip (120) and an electrostatic discharge protection member (140) on a lead frame (110) to which a molding member (130) is attached;
wire-bonding the light-emitting diode chip (120) and the electrostatic discharge protection member (140) to the lead frame (110); and
forming a bead member (150) covering a surface of the electrostatic discharge protection member (140),
wherein the bead member (150) comprises beads (151) inducing diffuse reflection of light emitted from the light-emitting diode chip (120) and incident on the electrostatic discharge protection member (140).

11. The method of claim 10, wherein mounting the light-emitting diode chip (120) and the electrostatic discharge protection member (140) on the lead frame (110) comprises attaching the light-emitting diode chip (120) and the electrostatic discharge protection member (140) to the lead frame (110) via an adhesive member (P).

12. The method of claim 10 or 11, wherein forming the bead member (150) comprises:
covering an outer surface of the electrostatic discharge protection member (140) with a resin dot including the beads (151); and
curing the resin dot.

13. The method of any of claims 10 to 12, further comprising:
filling a cavity inside of the molding member (130) with a resin layer (160),
wherein, preferably, the resin layer (160) is formed by filling a resin material in the cavity formed by the lead frame (110) and a wall of the molding member (130) and curing the resin material.

14. The light-emitting diode package (100) of any of claims 1 to 9, or the method of any of claims 10 to 13, wherein the electrostatic discharge protection member (140) is a Zener diode.

15. A light emitting device (1) comprising:
a control board (200) comprising leads that deliver external power and control signals on a substrate;
at least one light-emitting diode package (100) according to any of claims claim 1 to 9, or 14, mounted on the control board (200); and
a lens member (300) mounted on the control board (200) to cover each light-emitting diode package (100).
